# EUROPEAN PATENT SPECIFICATION

(11) **EP 3 811 090 B1**
(45) Date of publication and mention of the grant of the patent: **13.12.2023**
(21) Application number: 19745203.0
(22) Date of filing: 19.06.2019
(51) Int. Cl.: G01R 31/52, G01R 31/11

(54) **A SYSTEM AND METHOD FOR LOCATING FAULTS ON AN ELECTRICITY NETWORK**
SYSTEM UND VERFAHREN ZUR LOKALISIERUNG VON FEHLERN IN EINEM STROMNETZ
SYSTÈME ET PROCÉDÉ DE LOCALISATION DE DÉFAUTS DE FONCTIONNEMENT SUR UN RÉSEAU ÉLECTRIQUE

(30) Priority: 20.06.2018 GB 201810131
(43) Date of publication of application: 28.04.2021
(73) Proprietor: EA Technology Limited, Chester CH1 6ES (GB)
(72) Inventor: CODD, Peter Sandell, Chester CH1 6ES (GB)
(74) Representative: Prichard, Leslie Stephen
(86) International application number: PCT/GB2019/051719
(87) International publication number: WO 2019/243813

(56) References cited:
- GB-A- 2 548 007
- US-A- 4 165 482
- US-A- 4 739 276
- US-A- 5 345 180
- US-A- 5 381 348
- US-A- 5 751 149
- US-A1- 2017 176 511
- US-B2- 8 232 807

## Description

### TECHNICAL FIELD OF THE INVENTION

This present invention relates to systems and methods for locating faults on an electricity network. In particular, the present invention relates to systems and methods which use Time Domain Reflectometry (TDR) to locate faults on an electricity network.

### BACKGROUND

Time Domain Reflectometry (TDR) is a recognised method for determining the location of faults on low voltage (LV) networks. In such methods, a short duration voltage pulse with sharp rising edge is injected into a candidate cable of an electrical network on which a fault is known to exist. A high frequency, typically tens of MHz, monitoring circuit is used to record the high frequency voltages reflected back towards the monitoring circuit.

A change in impedance on the cable, such as that caused by a short circuit fault, will cause a perturbation in the received reflections. Comparing the traces from a faulted and nonfaulted network allows a perturbation most likely related to the fault to be observed. With knowledge of pulse propagation rates in cables, the measured time between pulse injection and the recognition of the reflection from the suspected fault impedance is used to determine the distance along the cable at which the perturbation (fault reflection) occurred.

Equipment to inject pulses and record traces can be installed at a substation end of a circuit or at a remote end. Installation of equipment at the substation end is relatively straightforward in terms of access to cables, power supplies and communications as well as offering a weather-protected and secure space. One such arrangement is described in GB 0773666 A, which utilises high-power electronic switches (thyratrons) to give an integrated current output proportional to the time between a pulse being sent, and received back, and therefore proportional to the distance of a fault down a single candidate cable.

There are however limiting disadvantages in presently known fault detection techniques that utilise injections from the substation end:
Most low voltage faults are transient and disappear when the voltage is removed. In order to locate these transient faults therefore the voltage must be retained on the circuit sustaining the fault. At the substation end this means that the protective element (e.g. a fuse or circuit breaker for instance) remains in service. In this case the TDR pulse is injected into the busbar rather than just the candidate cable. Where there are multiple cable connections at the busbar this is seen by the TDR pulse as a low impedance (the other feeder characteristic impedances in parallel) causing attenuation of the pulse voltage on the candidate cable. Significantly, reflections emanating back are similarly reduced in magnitude by the low impedance of the rest of the network connected to the substation busbars. The overall effect is a severe undesirable reduction in the sensitivity of the voltage measurement circuitry.

This disadvantage can be mitigated by siting the TDR equipment at the remote end of a branch. However, the practicality of installation is much reduced over substation measurements. This is particularly true if those measurements are required to be taken over an extended time such as when locating intermittent cable breakdowns.

This disadvantage can also be overcome at the substation end by introducing a series connected inductance between the injection point and the busbar. As it is in series with the main current carrying connection, the inductance must be rated for fault current. The series inductance appears as a high impedance to the injected TDR pulse and to the pulse reflections blocking their propagation to the busbar and resultant attenuation; the injection and reflection method is thus confined to the candidate circuit.

Provision of a series inductor capable of carrying load and fault current reduces the practicality of installation of the fault location system in a substation. Inductance is typically introduced by connecting a separate protection device to the candidate fuseway via flexible high current leads. The lead to the busbar side of the fuseway is coiled with several turns and the coils retained using cable ties thus introducing an air-core inductor into the busbar connection. One such arrangement is described in JP 2003057298 A, which utilises inductive coils to introduce a high impedance to allow a voltage reflection to be measured more easily in a candidate circuit.

Also, use of the TDR technique for locating intermittent cable breakdowns requires the equipment to be left unsupervised for an extended period, exacerbating the issue of bulky equipment not able to be retained within the footprint of a low voltage fuseboard.

Another prior art arrangement is described in US 4,887,041, which discloses a method and device for detecting developing ("incipient") faults in electric power cables. In operation, it locates the incipient faults using a technique that relies on the remote end of the line being terminated so as to produce pulse reflections caused by fault discharges themselves. The measured time difference between the injected pulse, and the reflected and re-reflected pulses, is used to calculate the location of the fault on a single candidate cable.

It is also known in the art to utilise pulse reflections in HV networks. For example, US 5,650,728 describes a HV line testing device for offline or out of service measurements and CN 103487727 A describes a cable sheath fault protection circuit which is located at the remote end of the cable for determining faults in HV single core cable sheaths. The latter document describes using a current transducer to measure the signals on a grounded cable sheath. It does not describe performing measurements on the bus section with multiple feeders and the discrimination problems associated with this, as described herein. Another offline measurement technique is described in CN 204086454 U, which discloses an AC signal source and pulse generator for connection to a candidate cable.

CN 1673764 A is a fault detection system for HV circuits that measures the pulse current that is injected on to all feeders and the relevant amplitudes and phases used to distinguish the source of the reflected perturbations. However, one of the problems with this approach is that computationally this requires sophisticated high-speed processing and detection algorithms, whereas, it is the object of the present invention to provide a system and method which is capable of using a switched coupling capacitor to enable the invention to detect and localise permanent faults and to detect the fault on multiple circuits connected to the busbar side of the current sensor and which provide substantial improvements in terms of cable discrimination.

One further prior art arrangement for use with LV cables is US 4,165,482 which utilises the reflected current pulse from a candidate circuit for locating a cable fault. It does not suggest in any way the use of a shunt capacitor on the busbar side of the device. A further example of a prior art arrangements is disclosed in US 5,345,180.

It is therefore an object of the present invention to provide the switched shunt capacitor which enables discrimination between faults on the circuit being monitored and faults elsewhere on the network.

It is also an object of the present invention to provide a system and method which enhances the signal strength of reflections from a candidate cable.

It is also an object of the present invention to provide a relatively compact and/or small form suitable to be accommodated within a unit housed on the fuseway and/or within the footprint of the fuseboard.

It is also an object of the present invention to provide a system which does not require a series inductor to reduce reflected signal attenuation.

### SUMMARY OF THE INVENTION

The present invention in its various aspects is as set out in the appended claims.

According to a first aspect of the present invention there is provided a system for locating faults on an electricity network, the system comprising: a pulse generator; a current sensor; and a shunt capacitor being connected to a candidate electrical cable on a busbar side relative to the current sensor; wherein the pulse generator is operable to introduce an investigatory pulse into the candidate electrical cable and wherein, upon encountering a fault, the investigating pulse causes a reflected pulse, and wherein the current sensor monitors the current of the reflected pulse to determine a characteristic of the encountered fault, and wherein reflected pulses from non-candidate electrical cables connected to the busbar are sunk and do not pass through the current sensor. The characteristic of the encountered fault may be the location of the fault on the electricity network.

The investigatory pulse is advantageously a short duration pulse with a sharp rising edge. The pulse could be either a voltage pulse or a current pulse. A preferred embodiment of the invention, described and illustrated in the present application, comprises a system for injecting a voltage pulse. Using a voltage pulse is advantageously easier to provide and is enabled by a more compact system. However, it will be appreciated that the present invention may also be worked in a system wherein the investigatory pulse is a current pulse, which is included within the scope of the present application.

The current sensor is advantageously a high frequency current measurement sensor.

The reflected pulse may be caused by interaction of the investigatory pulse with a change in impedance indicative of a fault in the candidate cable.

The shunt capacitor is advantageously connected to the candidate cable through a switch.

The switch is advantageously operable to disconnect the shunt capacitor from the candidate cable when an investigatory voltage pulse is introduced and connect the shunt capacitor to the candidate cable when the reflected pulse is being monitored.

The system may further comprise a protection device, wherein the shunt capacitor and current sensor are advantageously disposed on the network side of the protection device.

The shunt capacitor is advantageously operable to provide near zero impedance to a reflected pulse at the pulse frequencies and to provide a high impedance to the power frequencies.

The pulse generator and the shunt capacitor may be combined into a single coupling circuit. Alternatively, the pulse generator and the shunt capacitor may be separate, each having a separate switch dedicated to each function.

According to a second aspect of the present invention there is provided a method for locating faults on an electricity network, the method comprising: providing a pulse generator; providing a current sensor; and providing a shunt capacitor being connected to a candidate electrical cable on a busbar side relative to the current sensor; whereby the pulse generator introduces an investigatory pulse into the candidate electrical cable and, upon encountering a fault, the investigating pulse causes a reflected pulse, whereby the current sensor monitors the current of the reflected pulse to determine a characteristic of the encountered fault, and wherein reflected pulses from non-candidate electrical cables connected to the busbar are sunk and do not pass through the current sensor. The characteristic of the encountered fault may be the location of the fault on the electricity network.

The investigatory pulse is advantageously a short duration pulse with a sharp rising edge.

The current sensor is advantageously a high frequency current measurement sensor.

The reflected pulse may be caused by interaction of an investigatory voltage pulse with a change in impedance indicative of a fault in the candidate cable.

The shunt capacitor is advantageously connected to the candidate cable through a switch.

The switch is advantageously operable to disconnect the shunt capacitor from the candidate cable when the investigatory voltage pulse is introduced and connect the shunt capacitor to the candidate cable when the reflected pulse is being monitored.

The method may further comprise: providing a protection device; whereby the shunt capacitor and current sensor are advantageously disposed on the network side of the protection device.

The shunt capacitor is advantageously operable to provide near zero impedance to a reflected pulse at the pulse frequencies and to provide high impedance to the power frequencies.

The pulse generator and the shunt capacitor may be combined into a single coupling circuit.

### BRIEF DESCRIPTION OF THE DRAWINGS

The present invention will now be described by way of example only, and with reference to the accompanying drawing, in which:

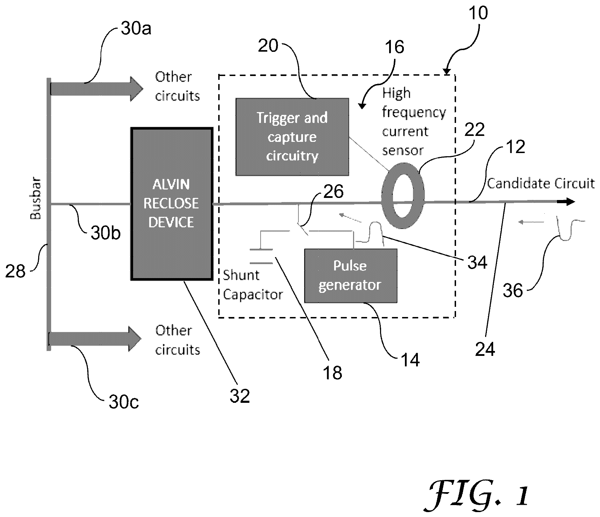

Figure 1 is a schematic of a system for locating faults on an electricity network according to the present invention.

### DETAILED DESCRIPTION OF THE PREFERRED EMBODIMENTS

Referring to Figure 1, a system 10 for locating faults on an electricity network 12 according to a first aspect of the present invention comprises a pulse generator 14, a measurement subsystem 16 and a shunt capacitor 18. The measurement subsystem 16 comprises trigger and capture circuitry 20 and a high frequency current sensor 22.

In a preferred embodiment, the pulse generator 14 and the shunt capacitor 18 is connected to a candidate cable 24 of the electricity network 12 through a switch 26.

A standard fuseboard has a busbar 28 to which electrical cables 30a-30c are connected for supplying electricity to the electrical network 12. In this description of the system 10, electrical cable 30b has been selected as the candidate cable 24 for determining characteristics of the fault on the electricity network 12.

The shunt capacitor 18 is connected to the candidate cable on the busbar 28 side relative to the high frequency current sensor 22.

The system 10 may be deployed within a protection device 32, such as, for example, an ALVIN^{®} Reclose device available from EA Technology Limited. In an alternative embodiment the system 10 may alternatively be separate to, or in tandem with, the protection device 32. The skilled person will appreciate that that however it is deployed, the compactness of the system 10 enables it to be installed within the footprint of the fuseboard. The shunt capacitor 18 and the high frequency current sensor 22 are connected on the electrical side of the protection device 32.

In a preferred embodiment, the pulse generator 14 and the shunt capacitor 18 are combined into a single coupling circuit.

According to a second aspect of the present invention, a method for locating faults on an electricity network comprises: providing a pulse generator 14; providing a shunt capacitor 18; and providing a current sensor 22.

In use, the pulse generator 14 introduces an investigatory pulse 34 into a candidate electrical cable 24 of an electricity network 12. Upon encountering a fault on the electricity network 12, the investigating pulse 34 causes a reflected pulse 36 due to a change in impedance indicative of a fault. The current sensor 22 monitors the candidate cable 24 for the current of the reflected pulse to determine a characteristic of the encountered fault. The characteristic of the encountered fault may be the location of the fault on the electricity network.

Therefore, rather than monitoring for the voltage of the pulse reflection, the system 10, according to the present invention, monitors for the current caused by the reflections of the reflected pulse 36 using a high-frequency (tens of MHz) current measurement sensor 22.

The investigatory pulse 34 is a Time Domain Reflectometry (TDR) pulse having a short duration with a sharp rising edge. The investigatory pulse 34 is injected into the candidate cable electrical cable 24 of an electricity network 12, as is the case for voltage sensing TDR methods.

Reflected pulses 36 from discontinuities in impedance on the electricity network 12 are returned back toward the high frequency current sensor 22. Without the shunt capacitor 18, the multiple other circuits 30a and 30b connected at the busbar 28 appear to the reflections as low impedance and therefore cause a high current to flow back through the high frequency current sensor 22. The same mechanism which reduced the magnitude of the voltage signal to be measured, increases the magnitude of the current signal. Moreover, the lower the impedance of the rest of the network, the more effective the method becomes. Accordingly, the system and method of the present invention is specifically advantageous because it works with multiple cable substations where traditional voltage TDR methods fail due to increased attenuation and improves further this situation by forcing a short circuit impedance to the high frequency reflections thus allowing the invention to be used equally well on substations with only one cable circuit as those with significantly more.

A further inventive step ensures the method can still be applied even when low impedance, due to the rest of the network connected to the busbars 28, cannot be guaranteed, for example, in single feeder substations or when the protection device 32 on the candidate cable 24 has operated.

The switch 26 switches the shunt capacitor 18 into and out of the candidate cable 24 on the busbar 28 side of the high frequency current sensor 22. Any combination of switch may be used to function in the same way and the switch or switches may be, for example, transistors or other semiconductor devices.

It should be noted that both the shunt capacitor 18 and high frequency current sensor 22 are on the circuit side of the protection device to enable the method to be used on permanent faults where the connection to the busbar 28 may be open.

The capacitor 18 is switched out of candidate cable 24 when the investigatory pulse 34 is injected but then switched back into candidate cable 24 for the period where the reflection pulses 36 are monitored. For example, this may only be for 5 microseconds every 500 microseconds, making the capacitor 18 less susceptible to damage by other, general, high frequency network effects should they arise anywhere on the candidate cable 24 or other busbar connected circuits.

The capacitor 18 presents near zero impedance to the voltages of the reflected pulses 36 at the TDR pulse frequencies whilst offering a high impedance to the power frequencies which allow it to be left in circuit for the monitoring period.

As it is on the busbar 28 side of the high frequency current sensor 22, voltages of the reflected pulses 36 cause high currents to flow through the sensor 22 independent of the impedance presented by the busbar 28.

Reflections from the non-candidate circuits 30a and 30c connected to the busbar 28 are sunk and do not pass through the high frequency current sensor 22. Capacitors rated to operate at the power frequency voltages on low voltage networks are widely available and compact enough to be housed in the footprint of a modified ALVIN^{®} Reclose device and thus inserted directly into fuseway of a live switchboard or other compact fault location device operating in tandem with an ALVIN^{®} device, or standalone.

Coupling the current sensing TDR equipment 16 with a low voltage reclose device 32 also provides a convenient means to connect the sensing elements 22 to the candidate cable 24 whilst also providing circuit protection and fault management facilities during the period of location. However, it should be noted that availability of an ALVIN^{®} Reclose device is not a prerequisite for the deployment of the system 10, accordingly to the present invention.

Accordingly, the system and method according to the present invention is of a relatively small and/or compact size, such that it can be accommodated within a unit housed on the fuseway and/or within the footprint of the fuseboard, and functions to enhance the signal strength of reflections from a candidate cable feeder. Moreover, provision of a series inductor, as required in known systems to reduce reflected signal attenuation, is no longer required.

When used in this specification and claims, the terms "comprises" and "comprising" and variations thereof mean that the specified features, steps or integers are included. The terms are not to be interpreted to exclude the presence of other features, steps or components.

The features disclosed in the foregoing description, or the following claims, or the accompanying drawings, expressed in their specific forms or in the terms of a means for performing the disclosed function, or a method or process for attaining the disclosed result, as appropriate, separately, or in any combination of such features, can be utilised for realising the invention in diverse forms thereof.

The invention is not intended to be limited to the details of the embodiments described herein, which are described by way of example only. It will be understood that features described in relation to any particular embodiment can be featured in combination with other embodiments.

It is contemplated by the inventor that various alterations and modifications may be made to the invention without departing from the scope of the invention as defined by the claims.

## Claims

1. A system (10) for locating faults on an electricity network (12) which comprises a busbar (28) to which electrical cables (30a - 30c) are connected, the system (10) comprising:
a pulse generator (14);
a current sensor (22); and
a shunt capacitor (18) being connected to a candidate electrical cable (30b) on a busbar (28) side relative to the current sensor (22);
wherein the pulse generator (14) is operable to introduce an investigatory pulse (34) into the candidate electrical cable (30b) and wherein, upon encountering a fault, the investigating pulse (34) causes a reflected pulse (36), and wherein the current sensor (22) monitors the current of the reflected pulse (36) to determine a characteristic of the encountered fault, and wherein reflected pulses (36) from non-candidate electrical cables (30a, 30c) connected to the busbar (28) are sunk and do not pass through the current sensor (22).

2. A system (10) as claimed in claim 1, wherein the investigatory pulse (34) is a short duration pulse with a sharp rising edge.

3. A system (10) as claimed in claims 1 or 2, wherein the current sensor (22) is a high frequency current measurement sensor.

4. A system (10) as claimed in any of the preceding claims, wherein the reflected pulse (36) is caused by interaction of the investigatory pulse (34) with a change in impedance indicative of a fault in the candidate cable (30b).

5. A system (10) as claimed in any of the preceding claims, wherein the shunt capacitor (18) is connected to the candidate cable through a switch (26), wherein the switch (26) is operable to disconnect the shunt capacitor (18) from the candidate cable (30b) when an investigatory voltage pulse (34) is introduced and connect the shunt capacitor (18) to the candidate cable (30b) when the reflected pulse (36) is being monitored.

6. A system (10) as claimed in any of the proceeding claims, further comprising a protection device (32) and wherein the shunt capacitor (18) and current sensor (22) are disposed on the network side of the protection device (32).

7. A system (10) as claimed in any of the preceding claims, wherein the shunt capacitor (18) is operable to provide near zero impedance to a reflected pulse (36) at the pulse frequencies and to provide a high impedance to the power frequencies.

8. A system (10) as claimed in any of the preceding claims, wherein the pulse generator (14) and the shunt capacitor (18) are combined into a single coupling circuit.

9. A method for locating faults on an electricity network (12) which comprises a busbar (28) to which electrical cables (30a - 30c) are connected, the method comprising:
providing a pulse generator (14);
providing a current sensor (22); and
providing a shunt capacitor (18) being connected to a candidate electrical cable (30b) on a busbar (28) side relative to the current sensor (22);
whereby the pulse generator (14) introduces an investigatory pulse (34) into the candidate electrical cable (30b) and, upon encountering a fault, the investigating pulse (34) causes a reflected pulse (36), whereby the current sensor (18) monitors the current of the reflected pulse (36) to determine a characteristic of the encountered fault, and wherein reflected pulses (36) from non-candidate electrical cables (30a, 30c) connected to the busbar (28) are sunk and do not pass through the current sensor (22).

10. A method as claimed in claim 9, whereby the investigatory pulse (34) is a short duration pulse with a sharp rising edge and/or optionally whereby the current sensor (22) is a high frequency current measurement sensor.

11. A method as claimed in claims 9 or 10, whereby the reflected pulse (36) is caused by interaction of the investigatory pulse (34) with a change in impedance indicative of a fault in the candidate cable (30b).

12. A method as claimed in claims 9 to 11, whereby the shunt capacitor (18) is connected to the candidate cable (30b) through a switch (26), wherein the switch (26) is operable to disconnect the shunt capacitor (18) from the candidate cable (30b) when an investigatory voltage pulse (34) is introduced and connect the shunt capacitor (18) to the candidate cable (30b) when the reflected pulse (36) is being monitored.

13. A method as claimed in claims 9 to 12, further comprising:
providing a protection device (32);
whereby the shunt capacitor (18) and current sensor (22) are disposed on the network side of the protection device (32).

14. A method as claimed in in claims 9 to 13, whereby the shunt capacitor (18) is operable to provide near zero impedance to a reflected pulse (36) at the pulse frequencies and to provide high impedance to the power frequencies.

15. A method as claimed in claims 9 to 14, whereby the pulse generator (14) and the shunt capacitor (18) are combined into a single coupling circuit.

## Patentansprüche

1. System (10) zur Lokalisierung von Fehlern in einem Stromnetz (12), das eine Sammelschiene (28) umfasst, woran Stromkabel (30a - 30c) angeschlossen sind, wobei das System (10) umfasst:
einen Impulsgenerator (14);
einen Stromsensor (22); und
einen Nebenschlusskondensator (18), der an ein Kandidaten-Stromkabel (30b) auf einer Sammelschienen- (28) Seite bezogen auf den Stromsensor (22) angeschlossen ist;
wobei der Impulsgenerator (14) betreibbar ist, um einen Untersuchungsimpuls (34) in das Kandidaten-Stromkabel (30b) einzubringen und wobei, beim Auftreten eines Fehlers, der Untersuchungsimpuls (34) einen reflektierten Impuls (36) bewirkt und wobei der Stromsensor (22) den Strom des reflektierten Impulses (36) überwacht, um eine Charakteristik des aufgetretenen Fehlers zu bestimmen, und wobei reflektierte Impulse (36) aus Nicht-Kandidaten-Stromkabeln (30a, 30c), die an die Sammelschiene (28) angeschlossen sind, versenkt werden und nicht durch den Stromsensor (22) hindurchgehen.

2. System (10) nach Anspruch 1, wobei der Untersuchungsimpuls (34) ein Impuls kurzer Dauer mit einer scharfen ansteigenden Flanke ist.

3. System (10) nach Ansprüchen 1 oder 2, wobei der Stromsensor (22) ein Hochfrequenz-Strommesssensor ist.

4. System (10) nach einem der vorhergehenden Ansprüche, wobei der reflektierte Impuls (36) durch Wechselwirkung des Untersuchungsimpulses (34) mit einer Impedanzänderung, die indikativ für einen Fehler in dem Kandidatenkabel (30b) ist, verursacht wird.

5. System (10) nach einem der vorhergehenden Ansprüche, wobei der Nebenschlusskondensator (18) an das Kandidatenkabel durch einen Schalter (26) angeschlossen ist, wobei der Schalter (26) betreibbar ist, um den Nebenschlusskondensator (18) von dem Kandidatenkabel (30b) zu trennen, wenn ein Untersuchungsspannungsimpuls (34) eingebracht wird, und den Nebenschlusskondensator (18) an das Kandidatenkabel (30b) anzuschließen, wenn der reflektierte Impuls (36) überwacht wird.

6. System (10) nach einem der vorhergehenden Ansprüche, ferner umfassend eine Schutzvorrichtung (32) und wobei der Nebenschlusskondensator (18) und Stromsensor (22) auf der Netzseite der Schutzvorrichtung (32) angeordnet sind.

7. System (10) nach einem der vorhergehenden Ansprüche, wobei der Nebenschlusskondensator (18) betreibbar ist, um nahezu null Impedanz für einen reflektierten Impuls (36) bei den Impulsfrequenzen bereitzustellen und eine hohe Impedanz für die Netzfrequenzen bereitzustellen.

8. System (10) nach einem der vorhergehenden Ansprüche, wobei der Impulsgenerator (14) und der Nebenschlusskondensator (18) zu einer einzigen Kopplungsschaltung kombiniert sind.

9. Verfahren zur Lokalisierung von Fehlern in einem Stromnetz (12), das eine Sammelschiene (28) umfasst, woran Stromkabel (30a - 30c) angeschlossen sind, wobei das Verfahren umfasst:
Bereitstellen eines Impulsgenerators (14);
Bereitstellen eines Stromsensors (22); und
Bereitstellen eines Nebenschlusskondensators (18), der an ein Kandidaten-Stromkabel (30b) auf einer Sammelschienen- (28) Seite bezogen auf den Stromsensor (22) angeschlossen ist;
wodurch der Impulsgenerator (14) einen Untersuchungsimpuls (34) in das Kandidaten-Stromkabel (30b) einbringt und, beim Auftreten eines Fehlers, der Untersuchungsimpuls (34) einen reflektierten Impuls (36) bewirkt, wodurch der Stromsensor (18) den Strom des reflektierten Impulses (36) überwacht, um eine Charakteristik des aufgetretenen Fehlers zu bestimmen, und wobei reflektierte Impulse (36) aus Nicht-Kandidaten-Stromkabeln (30a, 30c), die an die Sammelschiene (28) angeschlossen sind, versenkt werden und nicht durch den Stromsensor (22) hindurchgehen.

10. Verfahren nach Anspruch 9, wodurch der Untersuchungsimpuls (34) ein Impuls kurzer Dauer mit einer scharfen ansteigenden Flanke ist und/oder optional, wodurch der Stromsensor (22) ein Hochfrequenz-Strommesssensor ist.

11. Verfahren nach Ansprüchen 9 oder 10, wodurch der reflektierte Impuls (36) durch Wechselwirkung des Untersuchungsimpulses (34) mit einer Impedanzänderung, die indikativ für einen Fehler in dem Kandidatenkabel (30b) ist, verursacht wird.

12. Verfahren nach Ansprüchen 9 bis 11, wobei der Nebenschlusskondensator (18) an das Kandidatenkabel (30b) durch einen Schalter (26) angeschlossen ist, wobei der Schalter (26) betreibbar ist, um den Nebenschlusskondensator (18) von dem Kandidatenkabel (30b) zu trennen, wenn ein Untersuchungsspannungsimpuls (34) eingebracht wird, und den Nebenschlusskondensator (18) an das Kandidatenkabel (30b) anzuschließen, wenn der reflektierte Impuls (36) überwacht wird.

13. Verfahren nach einem der Ansprüche 9 bis 12, ferner umfassend:
Bereitstellen einer Schutzvorrichtung (32);
wodurch der Nebenschlusskondensator (18) und der Stromsensor (22) auf der Netzseite der Schutzvorrichtung (32) angeordnet sind.

14. Verfahren nach Ansprüchen 9 bis 13, wodurch der Nebenschlusskondensator (18) betreibbar ist, um nahezu null Impedanz für einen reflektierten Impuls (36) bei den Impulsfrequenzen bereitzustellen und hohe Impedanz für die Netzfrequenzen bereitzustellen.

15. Verfahren nach Ansprüchen 9 bis 14, wodurch Impulsgenerator (14) und der Nebenschlusskondensator (18) zu einer einzigen Kopplungsschaltung kombiniert sind.

## Revendications

1. Un système (10) destiné à localiser des défauts sur un réseau électrique (12) lequel comprend une barre omnibus (28) à laquelle des câbles électriques (30a - 30c) sont connectés,
le système (10) comprenant :
un générateur d'impulsions (14) ;
un capteur de courant (22) ; et
un condensateur en parallèle (18) étant connecté à un câble électrique candidat (30b) sur un côté de la barre omnibus (28) par rapport au capteur de courant (22) ;
dans lequel le générateur d'impulsions (14) est actionnable pour introduire une impulsion d'investigation (34) dans le câble électrique candidat (30b) et dans lequel, lors de la rencontre d'un défaut, l'impulsion d'investigation (34) provoque une impulsion réfléchie (36), et dans lequel le capteur de courant (22) surveille le courant de l'impulsion réfléchie (36) pour déterminer une caractéristique du défaut rencontré, et dans lequel des impulsions réfléchies (36) provenant des câbles électriques non candidats (30a, 30c) connectés à la barre omnibus (28) sont irrécupérables et ne passent pas à travers le capteur de courant (22).

2. Un système (10) selon la revendication 1, dans lequel l'impulsion d'investigation (34) est une impulsion de courte durée avec un front montant en pente raide.

3. Un système (10) selon la revendication 1 ou 2, dans lequel le capteur de courant (22) est un capteur de mesure de courant haute fréquence.

4. Un système (10) selon l'une quelconque des revendications précédentes, dans lequel l'impulsion réfléchie (36) est provoquée par l'interaction de l'impulsion d'investigation (34) avec un changement d'impédance indiquant un défaut dans le câble candidat (30b).

5. Un système (10) selon l'une quelconque des revendications précédentes, dans lequel le condensateur en parallèle (18) est connecté au câble candidat par un commutateur (26), dans lequel le commutateur (26) est actionnable pour déconnecter le condensateur en parallèle (18) du câble candidat (30b) quand une impulsion de tension d'investigation (34) est introduite et pour connecter le condensateur en parallèle (18) au câble candidat (30b) quand l'impulsion réfléchie (36) est en train d'être surveillée.

6. Un système (10) selon l'une quelconque des revendications précédentes, comprenant en outre un dispositif de protection (32) et dans lequel le condensateur en parallèle (18) et le capteur de courant (22) sont disposés du côté réseau du dispositif de protection (32).

7. Un système (10) selon l'une quelconque des revendications précédentes, dans lequel le condensateur en parallèle (18) est actionnable pour fournir une impédance proche de zéro à une impulsion réfléchie (36) aux fréquences d'impulsion et pour fournir une impédance élevée aux fréquences d'alimentation.

8. Un système (10) selon l'une quelconque des revendications précédentes, dans lequel le générateur d'impulsions (14) et le condensateur en parallèle (18) sont combinés dans un seul circuit de couplage.

9. Un procédé destiné à localiser des défauts sur un réseau électrique (12) lequel comprend une barre omnibus (28) à laquelle des câbles électriques (30a - 30c) sont connectés, le procédé consistant à :
fournir un générateur d'impulsions (14) ;
fournir un capteur de courant (22) ; et
fournir un condensateur en parallèle (18) étant connecté à un câble électrique candidat (30b) sur un côté de la barre omnibus (28) par rapport au capteur de courant (22) ;
selon lequel le générateur d'impulsions (14) introduit une impulsion d'investigation (34) dans le câble électrique candidat (30b) et, lors de la rencontre d'un défaut, l'impulsion d'investigation (34) provoque une impulsion réfléchie (36), selon lequel le capteur de courant (18) surveille le courant de l'impulsion réfléchie (36) pour déterminer une caractéristique du défaut rencontré, et dans lequel des impulsions réfléchies (36) provenant des câbles électriques non candidats (30a, 30c) connectés à la barre omnibus (28) sont irrécupérables et ne passent pas à travers le capteur de courant (22).

10. Un procédé selon la revendication 9, selon lequel l'impulsion d'investigation (34) est une impulsion de courte durée avec un front montant en pente raide et/ou en option selon lequel le capteur de courant (22) est un capteur de mesure de courant haute fréquence.

11. Un procédé selon la revendication 9 ou 10, selon lequel l'impulsion réfléchie (36) est provoquée par l'interaction de l'impulsion d'investigation (34) avec un changement d'impédance indiquant un défaut dans le câble candidat (30b).

12. Un procédé selon les revendications 9 à 11, selon lequel le condensateur en parallèle (18) est connecté au câble candidat (30b) par un commutateur (26), dans lequel le commutateur (26) est actionnable pour déconnecter le condensateur en parallèle (18) du câble candidat (30b) quand une impulsion de tension d'investigation (34) est introduite et pour connecter le condensateur en parallèle (18) au câble candidat (30b) quand l'impulsion réfléchie (36) est en train d'être surveillée.

13. Un procédé selon les revendications 9 à 12, consistant en outre à :
fournir un dispositif de protection (32) ;
selon lequel le condensateur en parallèle (18) et le capteur de courant (22) sont disposés du côté réseau du dispositif de protection (32).

14. Un procédé selon les revendications 9 à 13, selon lequel le condensateur en parallèle (18) est actionnable pour fournir une impédance proche de zéro à une impulsion réfléchie (36) aux fréquences d'impulsion et pour fournir une impédance élevée aux fréquences d'alimentation.

15. Un procédé selon les revendications 9 à 14, selon lequel le générateur d'impulsions (14) et le condensateur en parallèle (18) sont combinés dans un seul circuit de couplage.
